(19) Europäisches Patentamt
European Patent Office
Office européen des brevets

(11) **EP 4 512 922 A1**

(12) **EUROPÄISCHE PATENTANMELDUNG**

(43) Veröffentlichungstag:
**26.02.2025 Patentblatt 2025/09**

(21) Anmeldenummer: 23192887.0

(22) Anmeldetag: **23.08.2023**

(51) Internationale Patentklassifikation (IPC):
*C22C 38/02* (2006.01)   *C22C 38/04* (2006.01)
*C22C 38/06* (2006.01)   *C23C 2/06* (2006.01)
*B32B 15/01* (2006.01)   *C21D 1/673* (2006.01)
*C22C 18/00* (2006.01)   *C23C 14/16* (2006.01)
*C22C 38/26* (2006.01)   *C22C 38/28* (2006.01)
*C22C 38/32* (2006.01)

(52) Gemeinsame Patentklassifikation (CPC):
**C22C 38/04; B32B 15/013; C21D 1/673;
C22C 18/00; C22C 38/02; C22C 38/06;
C22C 38/26; C22C 38/28; C22C 38/32; C23C 2/06;
C23C 14/16; C23C 16/545**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder: **ThyssenKrupp Steel Europe AG
47166 Duisburg (DE)**

(72) Erfinder:
• **Bienholz, Stefan
44795 Bochum (DE)**
• **Köyer, Maria
44141 Dortmund (DE)**
• **Stille, Sebastian
44263 Dortmund (DE)**

(74) Vertreter: **ThyssenKrupp Steel Europe AG
Patente/Patent Department
Kaiser-Wilhelm-Straße 100
47166 Duisburg (DE)**

(54) **STAHLFLACHPRODUKT MIT VERBESSERTEN VERARBEITUNGSEIGENSCHAFTEN NACH DER WARMUMFORMUNG**

(57) Die Erfindung betrifft ein Stahlflachprodukt zur Herstellung eines Blechformteils durch Warmumformen. Dabei weist das Stahlflachprodukt ein Stahlsubstrat auf, das aus einem Stahl, der 0,1 - 3 Gew.-% Mn und optional bis zu 0,01 Gew.-% B aufweist, besteht. Weiterhin weist das Stahlflachprodukt einen auf mindestens einer Seite des Stahlsubstrats angeordneten Schutzüberzug auf, wobei der Schutzüberzug einen mittleren Gehalt an Zn von 75 - 90 Gew.-% aufweist und im Übrigen aus Mn und unvermeidbaren Verunreinigungen besteht. Weiterhin weicht ein lokaler Gehalt an Zn um maximal 15 %, insbesondere maximal 10 %, von dem mittleren Gehalt an Zn ab.

**Beschreibung**

Die Erfindung betrifft ein Stahlflachprodukt für die Warmumformung sowie ein Verfahren zur Herstellung eines solchen Stahlflachproduktes. Weiterhin betrifft die Erfindung ein Blechformteil mit verbesserten Eigenschaften und ein Verfahren zur Herstellung eines solchen Blechformteil aus einem Stahlflachprodukt.

Wenn nachfolgend von einem "Stahlflachprodukt" oder auch von einem "Blechprodukt" die Rede ist, so sind damit Walzprodukte, wie Stahlbänder oder -bleche, gemeint aus den für die Herstellung von beispielsweise Karosseriebauteilen "Blechzuschnitte" (auch Platinen genannt) abgeteilt werden. "Blechformteile" oder "Blechbauteile" der erfindungsgemäßen Art sind aus derartigen Blechzuschnitten hergestellt, wobei hier die Begriffe "Blechformteil" und "Blechbauteil" synonym verwendet werden.

Alle Angaben zu Gehalten der in der vorliegenden Anmeldung angegebenen Stahlzusammensetzungen sind auf das Gewicht bezogen, sofern nicht ausdrücklich anders erwähnt. Alle nicht näher bestimmten, im Zusammenhang mit einer Stahllegierung stehenden "%-Angaben" sind daher als Angaben in "Gew.-%" zu verstehen. Mit Ausnahme der auf das Volumen (Angabe in "Vol.-%") bezogenen Angaben zum Restaustenit-Gehalt des Gefüges eines erfindungsgemäßen Blechformteils beziehen sich Angaben zu den Gehalten der verschiedenen Gefügebestandteile jeweils auf die Fläche eines Schliffs einer Probe des jeweiligen Erzeugnisses (Angabe in Flächenprozent "Flächen-%"), soweit nicht ausdrücklich anders angegeben. In diesem Text gemachte Angaben zu den Gehalten der Bestandteile einer Atmosphäre beziehen sich auf das Volumen (Angabe in "Vol.-%").

Aus dem Stand der Technik sind somit bereits Korrosionsschutzbeschichtungen für Stahlflachprodukte und warmumgeformte Stahlflachprodukte (Bauteile) bekannt, welche Zink und Mangan enthalten.

Ein hoher Anteil von Zink liefert einen guten kathodischen Korrosionsschutz, hat jedoch den Nachteil, dass der Schmelzpunkt von Zink mit 419,5 °C relativ niedrig liegt. Beim Verarbeitungsprozess der Warmumformung wird das Stahlflachprodukt auf Temperaturen oberhalb von AC3 erwärmt und anschließend schnell abgekühlt, so dass sich ein zumindest teilweise martensitisches Gefüge bildet. Flüssige Zinkphasen an der Oberfläche führen jedoch zu Flüssigmetallversprödung, bei der flüssiges Zink z. B. an den Korngrenzen in das Stahlsubstrat eintritt. Hierdurch kommt es zu mechanischen Schwachstellen beim finalen Bauteil.

Die Beilegierung von Mangan führt zu einer deutlichen Erhöhung des Schmelzpunktes, so dass die Gefahr von Flüssigmetallversprödung reduziert ist. Andererseits wirkt sich ein zu hoher ManganGehalt negativ auf den kathodischen Korrosionsschutz aus.

Aus der WO 2020/094285 A1 sind Schutzüberzüge bekannt, deren zwei Hauptbestandteile Mangan und Zink sind, wobei der Anteil der Gesamtmasse an Mangan im Schutzüberzug an der Gesamtmasse an Mangan und Zink größer ist als 25 %.

Aus der WO 2015/090621 A1 sind Schutzüberzüge aus Zn und Mn bekannt, wobei der ManganGehalt im Bereich von 19-30 Gew.-% liegt.

Die bereits bekannten Korrosionsschutzbeschichtungen, Stahlflachprodukte und Bauteile sowie die Verfahren zu ihrer jeweiligen Herstellung erscheinen jedoch noch nicht optimal. Beispielsweise kommt es bei bekannten Schutzüberzügen zu ungleichmäßigem Korrosionsschutz und unregelmäßigem Schweißverhalten. Daher besteht Bedarf an der Optimierung eines Schutzüberzuges mit Zink und Mangan.

Diese Aufgabe wird gelöst durch ein Stahlflachprodukt zur Herstellung eines Blechformteils durch Warmumformen. Dabei umfasst das Stahlflachprodukt

a) ein Stahlsubstrat, das aus einem Stahl, der 0,1-3 Gew.-% Mn und optional bis zu 0,01 Gew.-% B aufweist, besteht und

b) einen auf mindestens einer Seite des Stahlsubstrats angeordneten Schutzüberzug,

wobei der Schutzüberzug einen mittleren Gehalt an Zn von 75 - 90 Gew.-% aufweist und im Übrigen aus Mn und unvermeidbaren Verunreinigungen besteht. Zudem weicht ein lokaler Gehalt an Zn um maximal 15 %, insbesondere maximal 10 %, von dem mittleren Gehalt an Zn ab. Dabei beträgt der Anteil an unvermeidbaren Verunreinigungen insbesondere in Summe über alle Verunreinigungen maximal 2 Gew.-%.

Der Schutzüberzug besteht also aus Zink, Mangan und unvermeidbaren Verunreinigungen, wobei ein mittlerer Gehalt an Zink im Bereich von 75 - 90 Gew.-% liegt. Zusätzlich weicht der lokale Gehalt an Zn um maximal 15 % von dem mittleren Gehalt an Zn ab. Wenn beispielsweise der mittlere Gehalt an Zink bei 80 Gew.-% liegt, dann bedeutet eine Abweichung von maximal 15 %, dass der lokale Gehalt an Zn im Bereich von 68 - 92 Gew.-% liegt. Bezeichnet man den mittleren Gehalt an Zn mit $\overline{Zn}$ und den lokalen Gehalt an Zn mit $\widehat{Zn}$, so gilt:

$$0.85 \cdot \overline{Zn} \le \widehat{Zn} \le 1.15 \cdot \overline{Zn}$$

Da der Zink-Gehalt natürlich mathematisch auf 100 Gew.-% begrenzt ist, ist die obere Grenze so zu verstehen, dass sie nicht mehr als 100 Gew.-% beträgt. Die obere Grenze für den lokalen Zn-Gehalt ist also eigentlich der kleinere Wert von $1.15 \cdot \overline{Zn}$ und 100 Gew.-%:

$$0.85 \cdot \overline{Zn} \le \widehat{Zn} \le Min(1.15 \cdot \overline{Zn}; 100 \ Gew. - \%)$$

Entsprechendes gilt, wenn die Variation des Zn-Gehaltes bevorzugt maximal 10 % beträgt.

Unter dem lokalen Zn-Gehalt wird der Zn-Gehalt verstanden, der im metallographischen Längsschliff mittels REM-EDX nach DIN ISO 22309:2015 ermittelt wird. Die Beschleunigungsspannung der Elektronen wurde dabei auf 20 eV festgelegt. Mithilfe des Elektronenstrahls wird ein Messfeld von $50 \mu m$ Breite des Schutzüberzuges gerastert. Das kartesische Raster hat eine Rasterung von 50nm in beide Richtungen. Somit entsteht ein Mapping des Zn-Gehaltes über dem gesamten Schutzüberzug im Messfeld. Der maximale und der minimale Zn-Gehalt in diesem Messfeld geben die Variation des Zn-Gehaltes an.

Versuche haben gezeigt, dass nicht nur der mittlere Gehalt an Zink und Mangan für die Verarbeitungseigenschaften des Stahlflachproduktes und des daraus erzeugten Bauteils relevant sind, sondern besonders auch die lokale Verteilung dieser Elemente. Je größer die Variation des lokalen Zn-Gehalts ist, desto größer ist das Risiko, dass sich bei der späteren Erwärmung vor dem Umformen schmelzflüssige Phasen im Schutzüberzug bilden. Solche Phasen sollten soweit wie möglich vermieden werden, da sie einerseits zu Verschmutzungen von Ofenrollen führen können und andererseits das Eindringen von flüssigem Zink in das Stahlsubstrat ermöglichen, was wiederum zum Flüssigmetallversprödung führt.

Um einen weiteren Vorteil der geringen Variation zu verstehen, muss man den Erwärmvorgang vor dem Umformen genauer betrachten. Während dieses Aufheizens diffundiert Eisen aus dem Stahlsubstrat und es bildet sich ein Schutzüberzug mit zwei Schichten. In der ersten Legierungsschicht, die das Stahlsubstrat kontaktiert, bildet sich im Wesentlichen eine Eisen-Zink-Legierung. Hauptbestandteile dieser Schicht sind also Eisen und Zink. Der Mangan-Anteil wird zum großen Teil verdrängt in eine zweite Legierungsschicht. Diese zweite Legierungsschicht kontaktiert die erste Legierungsschicht und enthält als Hauptbestandteile Mangan und Zink. Ist nun lokal ein höherer Zink-Anteil im Schutzüberzug des Stahlflachproduktes vorhanden, so bildet sich in diesen Bereichen eine dickere erste Legierungsschicht aus, da mehr Zink zur Verfügung steht. In den zinkärmeren Bereichen des Schutzüberzuges bildet sich hingegen eine dünnere erste Legierungsschicht aus. Es kommt also zu einer Variation der Dicke der ersten Legierungsschicht.

Die erste Legierungsschichtdicke beeinflusst jedoch aufgrund des hohen Eisengehaltes maßgeblich das Schweißverhalten des fertigen Bauteils. Um ein gleichmäßiges Schweißverhalten zu erreichen, ist es vorteilhaft, wenn die Dicke der ersten Legierungsschicht um nicht mehr als 15% variiert. Dies wiederum lässt sich aufgrund des oben beschriebenen Mechanismus bevorzugt erreichen, wenn der lokale Gehalt an Zn um nicht mehr als 15 % variiert.

Bei einer bevorzugten Ausführungsform des Stahlflachprodukt beträgt der mittlere Zn-Gehalt 75-85 Gew.-%. Dieser Bereich hat sich als ein besonders guter Kompromiss zwischen der Erhöhung des Schmelzpunktes und dem kathodischen Korrosionsschutz herausgestellt.

In einer bevorzugten Ausführungsvariante weist der Korrosionsschutzüberzug eine Dicke von 1-20 $\mu m$, bevorzugt 1 - 10 $\mu m$. Besonders bevorzugt beträgt die Dicke 3 - 10 $\mu m$. Insbesondere beträgt die Dicke mindestens 5 $\mu m$. Weiterhin beträgt die Dicke insbesondere bis zu $8 \mu m$. Schichten unterhalb von 1 $\mu m$ bieten für typischerweise keinen ausreichenden Korrosionsschutz. Für typische automobile Bauteile aus Stahlflachprodukten wird bei einer Schichtdicke von $3 \mu m$ oder mehr ein ausreichender Korrosionsschutz bis zum Ende der Produktlebensdauer erreicht. Bis zu einer Dicke von 20 $\mu m$ ergibt sich ein verbesserter Korrosionsschutz. Ab dieser Dicke kommt es zu keiner signifikanten Verbesserung mehr. Zudem übermäßig dicke Schichten (größer 20 $\mu m$) sind aufgrund der entsprechend längeren Beschichtungsdauer und der höheren Materialkosten nicht bevorzugt.

Die genannten Bereiche haben sich als guter Kompromiss zwischen einem ausreichenden Korrosionsschutr und den Fertigungskosten, die mit der Schichtdicke steigen, erwiesen.

Das Stahlsubstrat ist aus einem Stahl, der 0,1 - 3 Gew.-% Mn und optional bis zu 0,01 Gew.-% B aufweist. Insbesondere ist das Gefüge des Stahls durch ein Warmumformen in ein martensitisches oder teilweise martensitisches Gefüge umwandelbar. Das Gefüge des Stahlsubstrates des Stahlbauteils ist also bevorzugt ein martensitisches oder zumindest teilweise martensitisches Gefüge, da dieses eine besonders hohe Härte aufweist.

Besonders bevorzugt ist das Stahlsubstrat ein Stahl, der neben Eisen und unvermeidbaren Verunreinigungen (in Gew.-%) aus

C:　　　0,04 - 0,45 Gew.-%,

(fortgesetzt)

| | |
|---|---|
| Si: | 0,02 - 1,2 Gew.-%, |
| Mn: | 0,5 - 2,6 Gew.-%, |
| Al: | 0,02 - 1,0 Gew.-%, |
| P: | ≤ 0,05 Gew.-%, |
| S: | ≤ 0,02 Gew.-%, |
| N: | ≤ 0,02 Gew.-%, |
| Sn: | ≤ 0,03 Gew.-% |
| As: | ≤ 0,01 Gew.-% |
| Ca: | ≤ 0,005 Gew.-% |

sowie optional einem oder mehreren der Elemente "Cr, B, Mo, Ni, Cu, Nb, Ti, V" in folgenden Gehalten

| | |
|---|---|
| Cr: | 0,08 - 1,0 Gew.-%, |
| B: | 0,001 - 0,010 Gew.-% |
| Mo: | ≤ 0,5 Gew.-% |
| Ni: | ≤ 0,5 Gew.-% |
| Cu: | ≤ 0,2 Gew.-% |
| Nb: | 0,01 - 0,2 Gew.-%, |
| Ti: | 0,01 - 0,10 Gew.-% |
| V: | ≤ 0,3 Gew.-% |
| W: | 0,001 - 1,00 % |

besteht.

Bei den Elementen P, S, N, Sn, As, Ca handelt es sich um Verunreinigungen, die bei der Stahlerzeugung nicht vollständig vermieden werden können. Gelegentlich wird Ca auch bewusst zur Abbindung von Schwefel hinzulegiert. In einem solchen Fall beträgt der Gehalt von Ca mindestens 0,001 Gew.-%. Maximal beträgt der Ca-Gehalt auch in diesem Fall 0,005 Gew.-%.

Neben diesen Elementen können auch noch weitere Elemente als Verunreinigungen im Stahl vorhanden sein. Diese weiteren Elemente werden unter den "unvermeidbaren Verunreinigungen" zusammengefasst. Bevorzugt beträgt der Gehalt an unvermeidbaren Verunreinigungen in Summe maximal 0,2 Gew.-%, bevorzugt maximal 0,1 Gew.-%. Die optionalen Legierungselemente Cr, B, Nb, Ti, für die eine Untergrenze angegeben ist, können auch in Gehalten unterhalb der jeweiligen Untergrenze als unvermeidbare Verunreinigungen im Stahlsubstrat vorkommen. In dem Fall werden sie ebenfalls zu den unvermeidbaren Verunreinigungen gezählt, deren Gesamtgehalt auf maximal 0,2 Gew.-%, bevorzugt maximal 0,1 Gew.-% begrenzt ist. Bevorzugt sind die individuellen Obergrenzen für die jeweilige Verunreinigung dieser Elemente wie folgt:

| | |
|---|---|
| Cr: | ≤ 0,050 Gew.-%, |
| B: | ≤ 0,0005 Gew.-% |
| Nb: | ≤ 0,005 Gew.-%, |
| Ti: | ≤ 0,005 Gew.-% |

Dabei sind diese bevorzugten Obergrenzen als alternativ oder gemeinsam zu betrachten. Bevorzugte Varianten des Stahls erfüllen also eine oder mehrere dieser vier Bedingungen.

Bei einer eine bevorzugten Ausführungsform beträgt der C-Gehalt des Stahls maximal 0,37 Gew.-% und/oder mindestens 0,06 Gew.-%. Bei besonders bevorzugten Ausführungsvarianten liegt der C-Gehalt im Bereich von 0,06 - 0,09 Gew.-% oder im Bereich von 0,11 - 0,25 Gew.-% oder im Bereich von 0,32 - 0,37 Gew.-%.

Bei einer eine bevorzugten Ausführungsform beträgt der Si-Gehalt des Stahls maximal 1,00 Gew.-% und/oder mindestens 0,06 Gew.-%.

Der Mn-Gehalt des Stahls beträgt bei einer bevorzugten Variante maximal 2,4 Gew.-% und/oder mindestens 0,75 Gew.-%. Bei besonders bevorzugten Ausführungsvarianten liegt der Mn-Gehalt im Bereich von 0,75 - 0,85 Gew.-% oder im Bereich von 1,0 - 1,6 Gew.-%.

Der Al-Gehalt des Stahls beträgt bei einer bevorzugten Variante maximal 0,75 Gew.-%, insbesondere maximal 0,5 Gew.-%, bevorzugt maximal 0,25 Gew.-%. Alternativ oder ergänzend beträgt der Al-Gehalt bevorzugt mindestens 0,02 %.

Zudem hat sich gezeigt, dass es hilfreich sein kann, wenn die Summe der Gehalte von Silizium und Aluminium begrenzt sind. Bei einer bevorzugten Variante beträgt daher die Summe der Gehalte von Si und Al (üblicherweise bezeichnet als Si + Al) maximal 1,5 Gew.-%, bevorzugt maximal 1,2 Gew.-%. Ergänzend oder alternativ beträgt die Summe der Gehalte von Si und Al mindestens 0,06 Gew.-%, bevorzugt mindestens 0,08 Gew.-%.

Bei den Elementen P, S, N handelt es sich um typische Verunreinigungen, die bei der Stahlerzeugung nicht vollständig vermieden werden können. Bei bevorzugten Varianten beträgt der P-Gehalt maximal 0,03 Gew.-%. Unabhängig davon beträgt der S-Gehalt bevorzugt maximal 0,012 %. Zusätzlich oder ergänzend beträgt der N-Gehalt bevorzugt maximal 0,009 Gew.-%.

Optional enthält der Stahl zudem Chrom mit einem Gehalt von 0,08 - 1,0 Gew.-%. Bevorzugt beträgt der Cr-Gehalt maximal 0,75 Gew.-%, insbesondere maximal 0,5 Gew.-%.

Im Falle einer optionale Zulegierung von Chrom ist bevorzugt die Summe der Gehalte von Chrom und Mangan begrenzt. Die Summe beträgt maximal 3,3 Gew.-%, insbesondere maximal 3,15 Gew.-%. Weiterhin beträgt die Summe mindestens 0,5 Gew.-%, bevorzugt mindestens 0,75 Gew.-%.

Bevorzugt enthält der Stahl optional zudem Bor mit einem Gehalt von 0,001 - 0,005 Gew.-%. Insbesondere beträgt der B-Gehalt maximal 0,004 Gew.-%.

Optional kann der Stahl Molybdän mit einem Gehalt von maximal 0,5 Gew.-% enthalten, insbesondere maximal 0,1 Gew.-%.

Weiterhin kann der Stahl optional Nickel enthalten mit einem Gehalt von maximal 0,5 Gew.-%, bevorzugt maximal 0,15 Gew.-%.

Optional kann der Stahl zudem Kupfer enthalten mit einem Gehalt von maximal 0,2 Gew.-%, bevorzugt maximal 0,15 Gew.-%.

Zudem kann der Stahl optional eines oder mehrere der Mikrolegierungselemente Nb, Ti und V enthalten. Dabei beträgt der optionale Nb-Gehalt mindestens 0,01 Gew.-%, insbesondere mindestens 0,02 Gew.-% und maximal 0,2 Gew.-%, bevorzugt maximal 0,08 Gew.-%, bevorzugt maximal 0,04 Gew.-%. Der optionale Ti-Gehalt beträgt mindestens 0,01 Gew.-% und maximal 0,08 Gew.-%, bevorzugt maximal 0,04 Gew.-%. Der optionale V-Gehalt beträgt maximal 0,3 Gew.-%, bevorzugt maximal 0,2 Gew.-%, insbesondere maximal 0,1 Gew.-%, bevorzugt maximal 0,05 Gew.-%.

Im Falle einer optionale Zulegierung von mehreren der Elemente Nb, Ti und V ist bevorzugt die Summe der Gehalte von Nb, Ti und V begrenzt. Die Summe beträgt maximal 0,1 Gew.-%, insbesondere maximal 0,068 Gew.-%. Weiterhin beträgt die Summe bevorzugt mindestens 0,015 Gew.-%.

Wolfram (W) kann optional in Gehalten von 0,001 - 1,0 Gew.-% zur Verlangsamung der Ferritbildung hinzulegiert werden. Ein positiver Effekt auf die Härtbarkeit ergibt sich bereits bei W-Gehalten von mindestens 0,001 Gew.-%. Aus Kostengründen wird maximal 1,0 Gew.-% Wolfram hinzulegiert.

Die vorstehenden Erläuterungen zu bevorzugten Stahlsubstraten gelten selbstverständlich ebenso für das Stahlsubstrat des, im nachfolgenden beschriebenen Blechformteils, sowie die Stahlsubstrate in den beschriebenen Herstellungsverfahren.

Bei einer bevorzugten Ausführungsvariante ist der Korrosionsschutzüberzug durch physikalische Gasphasenabscheidung (englisch: physical vapour deposition; PVD) aufgebracht. Es hat sich gezeigt, dass auf diese Weise die erfindungsgemäße Oberflächenstruktur einfach erreichen lässt.

Üblicherweise wird dazu ein Beschichtungsmaterial, welches zunächst in fester oder flüssiger Form vorliegt, durch physikalische Prozesse verdampft. Dies kann beispielsweise thermisch durch direktes Aufheizen des Beschichtungsmaterials (beispielsweise über einen elektrischen Lichtbogen), durch Beschuss mit einem Elektronen- oder Ionenstrahl oder durch Beleuchtung mit einem Laserstrahl geschehen. Damit die Dampfteilchen des verdampften Beschichtungsmaterials das zu beschichtende Werkstück erreichen können und nicht durch Kollision mit Gasteilchen der Umgebungsatmosphäre für die Beschichtung verloren gehen, wird das Verfahren zum PVD-Beschichten in einer Beschichtungskammer unter Unterdruck durchgeführt.

Dieses Beschichtungsverfahren hat verschiedene Vorteile. Zum einen sind derartige Verfahren dafür bekannt, dass sie prozessbedingt keinen oder nur sehr wenig Wasserstoff in das Startsubstrat eintragen. Zum anderen ist es nicht erforderlich, das Stahlsubstrat zu stark zu erhitzen. Bei einer Feuerverzinkung wird das Stahlsubstrat beispielsweise zwangsläufig auf Temperaturen von mehr als 460 °C (die Zinkbadtemperatur) aufgeheizt. Bei diesen Temperaturen wird jedoch ein harter Bestandteil des Substratgefüges, insbesondere Martensit, angelassen, wodurch die Charakteristik des Stahlsubstrates verloren geht.

Die erfindungsgemäße Aufgabe wird weiterhin gelöst durch ein Verfahren zum Herstellen eines beschriebenen Stahlflachprodukts mit mindestens den folgenden Schritten:

a) Herstellen oder Bereitstellen eines Stahlsubstrats
b) Optionales Entölen des Stahlsubstrates

c) Optionales Dekapieren des Stahlsubstrates

d) Optionales Erwärmen des Stahlsubstrates

e) Kontinuierliches Einschleusen des Stahlsubstrates in eine Beschichtungskammer mit einem Unterdruck

f) Applizieren des Schutzüberzugs mittels physikalischer Gasphasenabscheidung, wobei die Temperatur des Stahlsubstrates beim Applizieren des Schutzüberzuges mindestens 200 °C beträgt

g) Kontinuierliches Ausschleusen des Stahlsubstrates aus der Beschichtungskammer

Die Beschichtungsrate beim Applizieren des Korrosionsschutzüberzuges beträgt bevorzugt mindestens 0,5 $\mu$m/s. Bei zu hohen Beschichtungsraten kann es allerdings zu Instabilitäten im Beschichtungsprozess kommen. Besonders prozesssicher lässt sich die gewünschte Oberflächenstruktur bei Beschichtungsraten zwischen 1,0 $\mu$m/s und 100 $\mu$m/s, bevorzugt zwischen 2 $\mu$m/s und 20 $\mu$m/s erreichen.

Das kontinuierliche Einschleusen des Stahlsubstrates in die Beschichtungskammer und das kontinuierliche Ausschleusen des Stahlsubstrates aus der Beschichtungskammer hat den Vorteil, dass auf diese Weise Stahlbänder als Stahlsubstrat kontinuierlich behandelt und beschichtet werden können. Alternativ müssten zu Spulen aufgewickelte Stahlbänder in die Beschichtungskammer eingebracht, die Beschichtungskammer evakuiert und nach der Beschichtung wieder belüftet werden, um die Stahlbänder zu entnehmen. Dies wäre wesentlich aufwendiger als ein kontinuierliches Einschleusen und Ausschleusen.

Unter einer Beschichtungskammer mit einem Unterdruck wird im Sinne dieser Anmeldung eine Beschichtungskammer verstanden, deren Druck mindestens 10% unterhalb des Atmosphärendruckes der Umgebung liegt.

Bei einer bevorzugten Variante wird das kontinuierliche Einschleusen und/oder Ausschleusen mittels mindestens einer barometrischen Flüssigkeitsschleuse realisiert, die in der WO 2019/122131 A1 beschrieben ist.

Bei einer alternativen Variante wird das kontinuierliche Einschleusen und/oder Ausschleusen mittels mindestens einer Rollenschleuse realisiert.

Bei einer speziell weitergebildeten Variante erfolgt das kontinuierliche Einschleusen und/oder Ausschleusen über zwei oder mehr Schleusen in Form von Schleusenstufen, die den Druck stufenweise verringern (beim Einschleusen) bzw. stufenweise erhöhen (beim Ausschleusen).

Durch die Methode der physikalischen Gasphasenabscheidung in Kombination mit einer Temperatur des Stahlsubstrates beim Applizieren des Schutzüberzuges von mindestens 200 °C wird prozesssicher eine besonders homogene Verteilung der Elemente im Schutzüberzug erreicht. Auf diese Weise wird gewährleistet, dass der lokale Gehalt an Zn um maximal 10 % von dem mittleren Gehalt an Zn abweicht. Zudem führt die Temperatur des Stahlsubstrates zu einer erhöhten Mobilität der kondensierenden Atome. Hierdurch finden die kondensierenden Atome besser einen geeigneten Platz, was zu einer kompakteren Schicht führt. Um diese Effekte besonders gut nutzen zu können, ist es vorteilhaft, wenn die Temperatur des Stahlsubstrates unterhalb aber nahe des Schmelzpunktes des Schutzüberzuges liegt. Dann ist die Mobilität der kondensierenden Atome besonders hoch und es kommt effektiv zu der beschriebenen Durchmischung und Kompaktierung. Die Temperatur des Stahlsubstrates beträgt daher bevorzugt mindestens 250 °C, insbesondere mindestens 300 °C, bevorzugt mindestens 350 °C, insbesondere mindestens 400 °C. Andererseits kann sich eine zu hohe Temperatur auf die Eigenschaften des Stahlsubstrates auswirken. Beispielsweise kann es zum Anlassen des Stahlsubstrates kommen. Auch aus energetischen Gründen ist eine zu hohe Temperatur nicht wünschenswert. Bei den hier beschriebenen Stahlsubstraten hat sich eine maximale Temperatur des Stahlsubstrates beim Applizieren des Korrosionsschutzüberzuges von 600 °C, insbesondere von maximal 550 °C, bevorzugt maximal 500 °C als gut geeignet erwiesen.

Bei einer speziellen Weiterbildung findet das Applizieren des Korrosionsschutzüberzuges in einer Schutzgas-Atmosphäre mit einem Druck zwischen 1 mbar und 100 mbar, insbesondere zwischen 10 mbar und 100 mbar statt. Hierzu erfolgt das Applizieren des Korrosionsschutzüberzuges in einer gasdichten Beschichtungskammer. Über ein geeignetes Pumpsystem wird die Beschichtungskammer in einen Unterdruck versetzt. Das Pumpsystem ist so konzipiert, dass es den verwendeten Schutzgasstrom (s.u.) bei den angegebenen Drücken fördern kann. Der Unterdruck in der Beschichtungskammer beträgt also zwischen 1 mbar und 100 mbar, insbesondere zwischen 10 mbar und 100 mbar. Dies sorgt dafür, dass wenig Beschichtungsmaterial durch Streuung an Teilchen in der Beschichtungskammer für die Beschichtung verloren geht. Gleichzeitig liegt der Druck in einem Bereich, der bei der großtechnischen Anwendung in industriellen Anlagen, beispielsweise bei der Beschichtung von Stahlbändern, mit vertretbarem Aufwand realisierbar ist. Bevorzugt ist die Beschichtungskammer gemäß der WO 2016/042079 A1 aufgebaut.

Insbesondere weist die die Schutzgas-Atmosphäre einen Sauerstoffanteil von weniger als 5 Vol.-%, bevorzugt weniger als 2 Vol.-%, insbesondere weniger als 1 Vol.-% auf. Hierdurch wird sichergestellt, dass es nicht zu unerwünschter Oxidation des heißen Stahlsubstrates kommt. Die Schutzgas-Atmosphäre ist bevorzugt eine Inertgas-Atmosphäre, insbesondere eine StickstoffAtmosphäre und/oder eine Argon-Atmosphäre, das heißt die Schutzgas-Atmosphäre besteht aus ausschließlich einem Inertgas, insbesondere Stickstoff oder Argon oder einer Mischung von Stickstoff und Argon und technisch unvermeidbaren Verunreinigungen. Alternativ ist die Schutzgas-Atmosphäre eine Inertgas-Atmosphäre mit Wasserstoffbeimischung. In diesem Fall besteht die Schutzgas-Atmosphäre aus bis zu 8 Vol.-% Wasserstoff, Rest Inertgas (insbesondere Stickstoff oder Argon oder einer Mischung aus Stickstoff und Argon) und technisch unvermeidbaren Verunreinigungen.

Gemäß einer bevorzugten Ausführungsform ist vorgesehen, dass das Applizieren des Korrosionsschutzüberzugs mittels physikalischer Gasphasenabscheidung auf das Stahlsubstrat erfolgt, indem das Stahlsubstrat in einer Beschichtungskammer bereitgestellt wird, wobei der Druck in der Beschichtungskammer reguliert wird. Dabei wird eine Legierung mit einem mittleren Gehalt an Zn von 75 - 90 Gew.-%, die im Übrigen aus Mn und unvermeidbaren Verunreinigungen besteht, als Beschichtungsmaterial an einer Einströmstelle in die Beschichtungskammer eingeströmt, wobei das Beschichtungsmaterial auf eine Temperatur temperiert wird.

Gemäß einer bevorzugten Ausführungsform der vorliegenden Erfindung ist vorgesehen, dass Druck und Temperatur so eingestellt werden, dass die Temperatur oberhalb des Taupunktes des Beschichtungsmaterials liegt. Bei einer Temperatur oberhalb des Taupunktes des Beschichtungsmaterials liegt dieses in seiner gasförmigen Phase vor. Wird der Druck angepasst, beispielsweise erhöht, so verschiebt sich der Taupunkt, im Beispiel hin zu höheren Temperaturen. Eine entsprechende Nachregulierung der Temperatur sorgt dafür, dass das Beschichtungsmaterial gasförmig vorliegt.

Die Erfindung betrifft weiterhin ein Blechformteil, aufweisend

a) ein Stahlsubstrat, das aus einem Stahl, der 0,1-3 Gew.-% Mn und optional bis zu 0,01 Gew.-% B aufweist, besteht und

b) einen auf mindestens einer Seite des Stahlsubstrats angeordneten Schutzüberzug.

Dabei umfasst der Schutzüberzug

- eine das Stahlsubstrat kontaktierende erste Legierungsschicht, deren zwei Hauptbestandteile Eisen und Zink sind und

- eine die erste Legierungsschicht kontaktierende zweite Legierungsschicht, deren zwei Hauptbestandteile Mangan und Zink sind

Hierbei weist der Schutzüberzug einen mittleren eisenlosen Massenanteil von Zn in Höhe von 75-90 Gew.-% auf. Zudem variiert eine Dicke der ersten Legierungsschicht um nicht mehr als 15 %. Unter dem Hauptbestandteil einer Schicht ist das Element zu verstehen mit dem höchsten Anteil in Gewichtsprozent. Wenn von mehreren Hauptbestandteilen die Rede ist, so sind damit ebenfalls die Elemente mit den höchsten Anteilen in Gewichtsprozent gemeint. Die erste Legierungsschicht, deren zwei Hauptbestandteile Eisen und Zink sind, kann also eine Vielzahl von Elementen enthalten, wobei Eisen und Zink die beiden Elemente mit dem höchsten Anteil in Gewichtsprozent sind.

Bei einer bevorzugten Ausführungsvariante besteht die erste Legierungsschicht aus Eisen, Zink und einem Rest, der maximal 20 Gew.-%, bevorzugt maximal 10 Gew.-% beträgt.

Bei einer weiteren bevorzugten Ausführungsvariante besteht die zweite Legierungsschicht aus Mangan, Zink und einem Rest der maximal 20 Gew.-%, bevorzugt maximal 10 Gew.-% beträgt.

Die Dickenvariation der ersten Legierungsschicht kann beispielsweise am metallographischen Längsschliff mittels REM auf einer Messlänge von 50 $\mu$m ermittelt werden.

Dies hat den Vorteil, dass das Blechformteil ein sehr gleichmäßiges Schweißverhalten aufweist. Das Schweißverhalten wird aufgrund des hohen Eisengehaltes maßgeblich von der Dicke der ersten Legierungsschicht bestimmt. Daher ist es vorteilhaft, wenn diese Dicke um nicht mehr als 15 %, bevorzugt um nicht mehr als 10 % variiert. Ein gleichmäßiges Schweißverhalten erleichtert das spätere Fügen des Blechformteils. Konkret zeigt sich bei den Versuchen, dass bei erfindungsgemäßen Blechformteilen der Kaltübergangswiderstand ebenfalls um nicht mehr als 15 % variiert.

Der Kaltübergangswiderstand wird gemäß der DIN ISO 18594 mit der Elektrodenform Typ A (16mm x 20mm) gemessen. Die Elektrodenkraft beträgt 3,5 kN, der Elektrodenstrom 10A (Gleichstrom). Der Widerstand wird nach 15 Sekunden Messzeit bestimmt.

Neben der guten Schweißbarkeit ist ein wesentlicher Vorteil des erfindungsgemäßen Blechformteils der gute Korrosionsschutz. Der mittlere Gehalt des Zn-Schutzüberzuges des Stahlflachproduktes von mindestens 75 Gew.-%, der sich in dem eisenlosen Massenanteil von Zn in Höhe von mindestens 75 Gew.-% des Schutzüberzuges des Blechformteils manifestiert, führt zu einem exzellenten kathodischen Korrosionsschutz. So beträgt das elektrochemische Potential der Oberfläche des Blechformteils in einem korrosiv wirkenden Medium maximal -0,30 V, bevorzugt maximal -0,35 V, insbesondere maximal -0,40 V. Das elektrochemische Potential ist also -0,30 V oder kleiner, das heißt negativer.

Das elektrochemische Potential wird dabei gemäß DIN-Norm DIN 50918 (2018.09) ("Ruhepotenzialmessung an homogenen Mischelektroden") bestimmt. Als Bezugselektrode kommt in allen Fällen das gleiche Stahlsubstrat ohne Beschichtung zum Einsatz. Es wird also die Differenz von beschichtetem zu unbeschichtetem Material betrachtet. Als korrosives Medium kommt bei der Messung eine wässrige, 5 %-NaCl-Lösung mit einem pH-Wert von 7 zum Einsatz, die typische Korrosionsbedingungen im Automobilbereich repräsentiert. Mit anderen Worten beträgt das elektrochemische Potential der Oberfläche des Blechformteils in einer wässrigen 5 %-NaCl-Lösung mit einem pH-Wert von 7 maximal -0,30 V.

Ein kleineres, das heißt negativeres, elektrochemisches Potential bedeutet, dass das Material unedler ist und daher stärker zur Korrosion neigt als das Stahlsubstrat. Je negativer das elektrochemische Potential ist, desto höher ist der kathodische Korrosionsschutz.

Die beschriebene Messung wird über eine Messzeit von mindestens 4 Stunden durchgeführt. Besonders bevorzugt beträgt das elektrochemische Potential der Oberfläche des Blechformteils in einem korrosiv wirkenden Medium nach einer Messzeit von 4 Stunden maximal -0,30 V, bevorzugt maximal -0,35 V, insbesondere maximal -0,40 V. Es kommt also nicht zu einer Passivierung, sondern der kathodische Korrosionsschutz bleibt über die gesamte Messzeit von 4 Stunden erhalten.

Der kathodische Korrosionsschutz des Schutzüberzuges wird zudem bewertet mittels der Messung der Kurzschlussstromstärke. Das Messverfahren entspricht dabei ebenfalls der DIN 50918 (2018.09). Bezugselektrode und korrosives Medium sind identisch zur Ruhepotentialmessung. Die Elektrodenfläche betrug jeweils 19,6 cm$^2$. Über 3 Stunden wurde dann der Kurzschlussstrom gemessen und hieraus eine mittlere Stromdichte bestimmt. Je höher die mittlere Stromdichte ist, desto besser ist der kathodische Korrosionsschutz. Als geeignet hat sich ein Wert von mindestens 0,1 A/m$^2$ , bevorzugt mindestens 0,2 A/m$^2$ erwiesen.

In einem bevorzugten Blechformteil ist die Dicke der ersten Legierungsschicht vorzugsweise größer oder gleich der Dicke der zweiten Legierungsschicht. Dies gilt vorzugsweise zumindest in 80 % der Gesamtfläche des Schutzüberzuges, besonders bevorzugt in zumindest 90 Gew.-% der Gesamtfläche des Schutzüberzuges. Auf diese Weise wird ein besonders effektiver Korrosionsschutz sichergestellt. Ausgehend von erfindungsgemäßen Blechformteile und unter Verwendung erfindungsgemäßer Herstellverfahren (siehe dazu im Detail unten) kann der Fachmann insbesondere über die Variation der Haltezeit bei ausgewählten hohen Temperaturen die Dicke der Legierungsschichten in gewünschter Weise einstellen.

Bevorzugt ist ein erfindungsgemäßes Blechformteil (wie vorstehend beschrieben, vorteilhafterweise wie vorstehend als bevorzugt bezeichnet), in dem Schutzüberzug weiter umfassend eine die zweite Legierungsschicht kontaktierende äußere Schicht umfassend Manganoxid, wobei vorzugsweise die Dicke der ersten Legierungsschicht größer oder gleich der Gesamtdicke der zweiten Legierungsschicht und der äußeren Schicht ist. Ein solches erfindungsgemäßes Blechformteil umfasst somit in der Korrosionsschutzbeschichtung neben der ersten Legierungsschicht und der zweiten Legierungsschicht auch noch zumindest die äußere Schicht umfassend Manganoxid. Diese wird bei der Herstellung des Blechformteils regelmäßig durch Reaktion von Mangan (wie es insbesondere auch in der zweiten Legierungsschicht vorhanden ist) mit Sauerstoff, z. B. dem Sauerstoff der Umgebungsluft, gebildet. Eine solche äußere Schicht umfassend Manganoxid zeichnet sich dadurch aus, dass sie durch ihre dunkle Färbung in einem Ofen nur wenig Strahlung reflektiert. Demzufolge nimmt die Oberfläche mehr Strahlungsenergie auf und lässt sich schnell aufheizen. Entsprechende Vorteile betreffen auch insbesondere das erfindungsgemäße Herstellverfahren.

Die Erfindung betrifft ferner ein Verfahren zum Herstellen eines Blechformteils, insbesondere eines Blechformteils wie zuvor beschrieben, umfassend folgende Arbeitsschritte:

a) Bereitstellen eines Blechzuschnitts aus einem Stahlflachprodukt nach einer der zuvor erläuterten Ausführungsvarianten;

b) Erwärmen des Blechzuschnitts derart, dass zumindest teilweise die AC3-Temperatur des Zuschnitts überschritten ist und die Temperatur $T_{Einlg}$ des Zuschnitts beim Einlegen in ein für ein Warmpressformen vorgesehenes Umformwerkzeug (Arbeitsschritt c)) zumindest teilweise eine Temperatur oberhalb von Ms+100 °C aufweist, wobei Ms die Martensitstarttemperatur bezeichnet;

c) Einlegen des erwärmten Blechzuschnitts in ein Umformwerkzeug, wobei die für das Entnehmen aus der Erwärmungseinrichtung und das Einlegen des Zuschnitts benötigte Transferdauer $t_{Trans}$ höchstens 20 s, bevorzugt höchstens 15 s, beträgt;

d) Warmpressformen des Blechzuschnitts zu dem Blechformteil, wobei der Zuschnitt im Zuge des Warmpressformens über eine Dauer $t_{WZ}$ von mehr als 1 s mit einer zumindest teilweise mehr als 30 K/s betragenden Abkühlgeschwindigkeit $r_{WZ}$ auf die Zieltemperatur $T_{Ziel}$ abgekühlt und optional dort gehalten wird;

e) Entnehmen des auf die Zieltemperatur $T_{Ziel}$ abgekühlten Blechformteils aus dem Werkzeug.

Beim erfindungsgemäßen Verfahren wird somit ein Zuschnitt aus einem, entsprechend den voranstehenden Erläuterungen in geeigneter Weise ausgeführten, Stahlflachprodukt bereitgestellt (Arbeitsschritt a)), der dann in an sich bekannter Weise so erwärmt wird, dass zumindest teilweise die AC3 Temperatur des Zuschnitts überschritten ist und die Temperatur $T_{Einlg}$ des Zuschnitts beim Einlegen in ein für ein Warmpressformen vorgesehenes Umformwerkzeug (Arbeitsschritt c)) zumindest teilweise eine Temperatur oberhalb von Ms+100 °C beträgt. Hierbei bezeichnet Ms die Martensitstarttemperatur. Unter teilweisem Überschreiten einer Temperatur (hier AC3 bzw. Ms+100 °C) wird im Sinne dieser Anmeldung verstanden, dass mindestens 30 %, insbesondere mindestens 60 %, des Volumens des Zuschnitts eine entsprechende Temperatur überschreiten. Beim Einlegen in das Umformwerkzeug weist also mindestens 30 % des Zuschnitts ein austenitisches Gefüge auf, d.h. die Umwandlung vom ferritischen ins austenitische Gefüge muss beim Einlegen in das Umformwerkzeug noch nicht abgeschlossen sein. Vielmehr können bis zu 70 % des Volumens des Zuschnitts beim Einlegen in das Umformwerkzeug aus anderen Gefügebestandteilen, wie angelassenem Bainit, angelassenem Martensit und/oder nicht bzw. teilweise rekristallisiertem Ferrit bestehen. Zu diesem Zweck können bestimmte Bereiche des Zuschnitts während der Erwärmung gezielt auf einem niedrigeren Temperaturniveau gehalten werden als andere. Hierzu kann die Wärmezufuhr gezielt nur auf bestimmte Abschnitte des Zuschnitts gerichtet werden oder die Teile, die weniger erwärmt werden sollen, gegen die Wärmezufuhr abgeschirmt werden. In dem Teil des Zuschnittmaterials, dessen Temperatur niedriger bleibt, entsteht im Zuge der Umformung im Werkzeug kein oder nur deutlich weniger Martensit, so dass das Gefüge dort deutlich weicher ist als in den jeweils anderen Teilen, in denen ein martensitisches Gefüge vorliegt. Auf diese Weise kann im jeweils geformten Blechformteil gezielt ein weicherer Bereich eingestellt werden, indem beispielsweise eine für den jeweiligen Verwendungszweck optimale Zähigkeit vorliegt, während die anderen Bereiche des Blechformteils eine maximierte Festigkeit besitzen.

Maximale Festigkeitseigenschaften des erhaltenen Blechformteils können dadurch ermöglicht werden, dass die zumindest teilweise im Blechzuschnitt erreichte Temperatur zwischen Ac3 und 1000 °C, bevorzugt zwischen 850 °C und 950 °C liegt.

Eine optimal gleichmäßige Eigenschaftsverteilung lässt sich dadurch erreichen, dass der Zuschnitt im Arbeitsschritt b) vollständig durcherwärmt wird.

Bei einer bevorzugten Ausführungsvariante beträgt die mittlere Aufheizgeschwindigkeit $r_{Ofen}$ des Blechzuschnittes beim Erwärmen in Schritt b) mindestens 3 K/s, bevorzugt mindestens 5 K/s, insbesondere mindestens 10 K/s, bevorzugt mindestens 15 K/s. Die mittlere Aufheizgeschwindigkeit $r_{Ofen}$ ist dabei als mittlere Aufheizgeschwindigkeit von 30 °C auf 700 °C zu verstehen.

Bei einer bevorzugten Ausführungsvariante erfolgt die Erwärmung in einem Ofen mit einer Ofentemperatur $T_{Ofen}$ von mindestens 850 °C, bevorzugt mindestens 880 °C, besonders bevorzugt mindestens 900 °C, insbesondere mindestens 920 °C, und maximal 1000 °C, bevorzugt maximal 950 °C, besonders bevorzugt maximal 930 °C.

Bevorzugt beträgt der Taupunkt im Ofen beträgt hierbei mindestens -20 °C, bevorzugt mindestens -15 °C, insbesondere mindestens -5 °C, besonders bevorzugt mindestens 0 °C, insbesondere mindestens 5 °C und maximal +25 °C, bevorzugt maximal + 20 °C insbesondere maximal +15 °C.

Bei einer speziellen Ausführungsvariante erfolgt die Erwärmung in Schritt b) stufenweise in Bereichen mit unterschiedlicher Temperatur. Insbesondere erfolgt die Erwärmung in einem Rollenherdofen mit unterschiedlichen Heizzonen. Hierbei erfolgt die Erwärmung in einer ersten Heizzone mit einer Temperatur (sogenannte Ofeneinlauftemperatur) von mindestens 650 °C, bevorzugt mindestens 680 °C, insbesondere mindestens 720 °C. Maximal beträgt die Temperatur in der ersten Heizzone bevorzugt 900 °C, insbesondere maximal 850 °C. Weiterhin bevorzugt beträgt die maximale Temperatur aller Heizzonen im Ofen maximal 1200 °C, insbesondere maximal 1000 °C, bevorzugt maximal 950 °C, besonders bevorzugt maximal 930 °C.

Die Gesamtzeit im Ofen $t_{Ofen}$, die sich aus einer Erwärmungszeit und einer Haltezeit zusammensetzt, beträgt bei beiden Varianten (konstante Ofentemperatur, stufenweise Erwärmung) bevorzugt mindestens 2 Minuten, insbesondere mindestens 3 Minuten, bevorzugt mindestens 4 Minuten. Weiterhin beträgt die Gesamtzeit im Ofen bei beiden Varianten bevorzugt maximal 20 Minuten, insbesondere maximal 15 Minuten, bevorzugt maximal 12 Minuten, insbesondere maximal 8 Minuten. Längere Gesamtzeiten im Ofen haben den Vorteil, dass eine gleichmäßige Austenitisierung des Blechzuschnittes sichergestellt ist. Andererseits führt ein zu langes Halten oberhalb von Ac3 zu einer Kornvergröberung, die sich negativ auf die mechanischen Eigenschaften auswirkt.

Der so erwärmte Zuschnitt wird aus der jeweiligen Erwärmungseinrichtung, bei der es sich beispielsweise um einen konventionellen Erwärmungsofen, eine ebenso an sich bekannte Induktionserwärmungseinrichtung oder eine konventionelle Einrichtung zum Warmhalten von Stahlbauteilen handeln kann, entnommen und so schnell in das Umformwerkzeug transportiert, dass seine Temperatur beim Eintreffen in dem Werkzeug zumindest teilweise oberhalb von Ms+100 °C liegt, bevorzugt oberhalb von 600 °C, insbesondere oberhalb von 650 °C, besonders bevorzugt oberhalb von 700 °C. Hierbei bezeichnet Ms die Martensitstarttemperatur. Bei einer besonders bevorzugten Variante liegt die Temperatur zumindest teilweise oberhalb der AC1-Temperatur. Bei allen diesen Varianten beträgt die Temperatur insbesondere maximal 900 °C. Durch diese Temperaturbereiche wird insgesamt eine gute Umformbarkeit des Materials gewährleistet.

Im Arbeitsschritt c) wird der Transfer des austenitisierten Zuschnitts von der jeweils zum Einsatz kommenden Erwärmungseinrichtung zum Umformwerkzeug innerhalb von vorzugsweise höchstens 20s, insbesondere von maximal 15s absolviert. Ein derart schneller Transport ist erforderlich, um eine zu starke Abkühlung vor der Verformung zu vermeiden.

Das Werkzeug besitzt beim Einlegen des Zuschnitts typischerweise eine Temperatur zwischen Raumtemperatur (RT) und 200 °C, bevorzugt zwischen 20 °C und 180 °C, insbesondere zwischen 50 °C und 150 °C. Optional kann das Werkzeug in einer besonderen Ausführungsform zumindest bereichsweise auf eine Temperatur $T_{WZ}$ von mindestens 200 °C, insbesondere mindestens 300 °C temperiert sein, um das Bauteil nur partiell zu härten. Weiterhin beträgt die Werkzeugtemperatur $T_{WZ}$ bevorzugt maximal 600 °C, insbesondere maximal 550 °C. Es ist lediglich sicherzustellen, dass die Werkzeugtemperatur $T_{WZ}$ unterhalb der gewünschten Zieltemperatur $T_{Ziel}$ liegt. Die Verweilzeit im Werkzeug $t_{WZ}$ beträgt bevorzugt mindestens 2s, insbesondere mindestens 3s, besonders bevorzugt mindestens 5s. Maximal beträgt die Verweilzeit im Werkzeug bevorzugt 25s, insbesondere maximal 20s.

Die Zieltemperatur $T_{Ziel}$ des Blechformteils liegt zumindest teilweise unterhalb 400 °C, bevorzugt unterhalb 300 °C, insbesondere unterhalb von 250 °C, bevorzugt unterhalb von 200 °C, besonders bevorzugt unterhalb von 180 °C, insbesondere unterhalb von 150 °C. Alternativ liegt die Zieltemperatur $T_{Ziel}$ des Blechformteils besonders bevorzugt unter Ms-50 °C, wobei Ms die Martensitstarttemperatur bezeichnet. Weiterhin beträgt die Zieltemperatur des Blechformteils bevorzugt mindestens 20 °C, besonders bevorzugt mindestens 50 °C.

Die Martensitstarttemperatur eines im Rahmen der erfindungsgemäßen Vorgaben liegenden Stahls ist gemäß der Formel

$$Ms\ [°C] = (490,85 — 302,6\ \%C — 30,6\ \%Mn - 16,6\ \%Ni — 8,9\ \%Cr + 2,4\ \%Mo —- 11,3\ \%Cu + 8,58\ \%Co + 7,4\ \%W — 14,5\ \%Si)\ [°C/Gew.\text{-}\%]$$

zu berechnen, wobei hier mit %C der C-Gehalt, mit %Mn der Mn-Gehalt, mit %Mo der Mo-Gehalt, mit %Cr der Cr-Gehalt, mit %Ni der Ni-Gehalt, mit %Cu der Cu-Gehalt, mit %Co der Co-Gehalt, mit %W der W-Gehalt und mit %Si der Si-Gehalt des jeweiligen Stahls in Gew.-% bezeichnet sind.

Die AC1-Temperatur und die AC3-Temperatur eines im Rahmen der erfindungsgemäßen Vorgaben liegenden Stahls ist gemäß den Formeln

$$AC1[°C] = (739 — 22*\%C - 7*\%Mn + 2*\%Si + 14*\%Cr + 13*\%Mo - 13*\%Ni + 20*\%V\ )[°C/Gew.\text{-}\%]$$

und

$$AC3[°C] = (902 - 225*\%C + 19*\%Si - 11*\%Mn - 5*\%Cr + 13*\%Mo - 20*\%Ni + 55*\%V)[°C/Gew.\text{-}\%]$$

zu berechnen, wobei auch hiermit mit %C der C-Gehalt, mit %Si der Si-Gehalt mit %Mn der Mn-Gehalt mit %Cr der Cr-Gehalt, mit %Mo der Mo-Gehalt, mit %Ni der Ni-Gehalt und mit %V der Vanadium-Gehalt des jeweiligen Stahls bezeichnet sind (Brandis H 1975 TEW-Techn. Ber. 1 8 - 10)

Im Werkzeug wird der Zuschnitt somit nicht nur zu dem Blechformteil geformt, sondern gleichzeitig auch die Zieltemperatur abgeschreckt. Die Abkühlrate im Werkzeuge $r_{WZ}$ auf die Zieltemperatur beträgt insbesondere mindestens 20 K/s, bevorzugt mindestens 30 K/s, insbesondere mindestens 50 K/s, in besonderer Ausführung mindestens 100 K/s.

Nach dem Entnehmen des Blechformteils in Schritt e) erfolgt ein Abkühlen des Blechformteils auf eine Abkühltemperatur $T_{AB}$ von weniger als 100 °C innerhalb einer Abkühldauer $t_{AB}$ von 0,5 bis 600 s. Dies geschieht im Regelfall durch eine Luftabkühlung.

Bei dem erfindungsgemäßen Blechformteil handelt es sich bevorzugt um ein Bauteil für ein Landfahrzeug, Seefahrzeug oder Luftfahrzeug. Besonders bevorzugt handelt es sich um ein Automobilteil, insbesondere um ein Karosserieteil. Bevorzugt ist das Bauteil eine B-Säule, Längsträger, A-Säule, Schweller oder Querträger.

Näher erläutert wird die Erfindung im Zusammenhang mit den nachfolgenden Tabellen.

Zum Nachweis der Wirkung der Erfindung wurden mehrere Versuche durchgeführt. Dafür wurde in konventioneller Weise mittels Warmwalzen und Kaltwalzen Stahlbänder mit der Zusammensetzung gemäß Tabelle 1 und einer Dicke von 1,5 mm hergestellt. Diese wurden kontinuierlich in eine Beschichtungskammer eingeschleust und ausgeschleust. In der Beschichtungskammer wurde mittels physikalischer Gasphasenabscheidung ein Schutzüberzug appliziert. Die Zusammensetzung des Schutzüberzuges ist in Tabelle 2 angegeben. Die übrigen Parameter der Beschichtung sind in Tabelle 3 angegeben. In allen Fällen erfolgte die Beschichtung in einer Stickstoff-Atmosphäre, wobei die technisch unvermeidbaren Verunreinigungen (inklusive Sauerstoff) unter 3 Vol.-% lagen. Der Gehalt an Sauerstoff lag unter 1 Vol.-%. Der Druck in der Schutzgasatmosphäre betrug 50 mbar. Aus diesen Stahlbändern sind anschließend Zuschnitte in Form von 200 × 300 mm² großen Platten abgeteilt worden. Gleichzeitig wurden metallographische Längsschliffe angefertigt und der Zn-Gehalt mittels REM-EDX ermittelt. Es zeigte sich in allen Fällen, dass der lokale Zn-Gehalt um nicht mehr als 8% vom mittleren Zn-Gehalt abgewichen ist.

Die abgeteilten Platten wurden dann zu Blechformteilen in konventioneller Weise warmumgeformt. Dazu sind die Zuschnitte in einer Erwärmungseinrichtung, beispielsweise in einem konventionellen Erwärmungsofen, von Raumtemperatur mit einer mittleren Aufheizgeschwindigkeit $r_{Ofen}$ (zwischen 30°C und 700°C) in einem Ofen mit einer Ofentemperatur $T_{Ofen}$ erwärmt worden. Die Gesamtdauer im Ofen, die eine Erwärmen und eine Halten umfasst, ist mit $t_{Ofen}$ bezeichnet. Der Taupunkt der Ofenatmosphäre betrug in allen Fälle -5°C. Anschließend sind die Zuschnitte aus der Erwärmungseinrichtung entnommen und in ein Umformwerkzeug, welches die Temperatur $T_{WZ}$ besitzt, eingelegt worden. Beim Zeitpunkt des Entnehmens aus dem Ofen hatten die Zuschnitte die Ofentemperatur angenommen. Die sich aus der für das Entnehmen aus der Erwärmungseinrichtung, den Transport zum Werkzeug und das Einlegen ins Werkzeug zusammensetzende Transferdauer $t_{Trans}$ lag zwischen 5 und 14 s. Die Temperatur $T_{Einlg}$ der Zuschnitte beim Einlegen in das Umformwerkzeug lag in allen Fällen oberhalb der jeweiligen Martensitstarttemperatur +100 °C. Im Umformwerkzeug sind die Zuschnitte zum jeweiligen Blechformteil umgeformt worden, wobei die Blechformteile im Werkzeug mit einer Abkühlgeschwindigkeit $r_{WZ}$ auf die Zieltemperatur $T_{Ziel}$ abgekühlt wurden. Die Verweildauer im Werkzeug wird mit $t_{WZ}$ bezeichnet. Abschließend sind die Proben aus dem Werkzeug entnommen und an Luft auf Raumtemperatur abgekühlt worden. Die genauen Parameter der Warmumformung sind nochmals in Tabelle 4 zusammengefasst.

Von den so hergestellten Blechformteilen wurden ebenfalls metallographische Längsschliffe hergestellt, an denen Dicken der ersten und zweiten Legierungsschicht und die Dickenvariation der ersten Legierungsschicht ermittelt wurden. Die Ergebnisse sind in Tabelle 5 angegeben. Die oberflächennahe Oxidschicht konnte im REM-Bild nicht ermittelt werden und hat daher eine Dicke unterhalb von 1 $\mu$m.

Weiterhin wurden an den so hergestellten Blechformteilen der Kaltübergangswiderstand, die Potentialdifferenz zum unbeschichteten Material über einen Zeitraum von 4 Stunden und die mittlere Stromdichte bei der Messung des Kurzschlussstromes bestimmt. Die Messbedingungen waren dabei ausgeführt wie vorstehend erläutert. Die Ergebnisse sind in Tabelle 6 aufgeführt. Bei den Versuchen 1 und 2 lag der Kaltübergangswiderstand, vermutlich aufgrund des hohen Mangan-Gehaltes, oberhalb von 0,015 $\Omega$. Bei dem Versuch 7 lag der Kaltübergangswiderstand dagegen mit 0,0003 $\Omega$ zu niedrig. Bei einem zu hohen Widerstand ergibt sich beim Schweißen eine zu hohe Leistung (Widerstand * Stromstärke zum Quadrat), was tendenziell zu Spritzern von zu schnell aufschmelzendem Material führt. Dies kann kompensiert werden, in dem das Material vor dem Schweißen gestrahlt wird, um Manganoxid an der Oberfläche abzutragen. Dies ist jedoch ein unerwünschter zusätzlicher Arbeitsschritt. Bei einem zu niedrigen Widerstand ist ein sehr hoher Schweißstrom erforderlich, um die nötige Leistung zu erreichen. Bevorzugt ist der Bereich von 0,0005 $\Omega$ bis 0,01 $\Omega$. Bei den Versuche 3 bis 6 lag der Kaltübergangswiderstand in diesem bevorzugten Bereich.

Für die Versuche 3 bis 6 wurde zudem der Kaltübergangswiderstand an 20 unterschiedlichen Positionen des Bauteils gemessen. In allen Fällen variierte der Kaltübergangswiderstand um nicht mehr als 10 % über die Oberflächenposition.

In Tabelle 6 ist weiterhin das elektrochemische Potential angegeben. Da dieses als Differenz von beschichtetem zu unbeschichtetem Material ermittelt wird, sind die jeweiligen Spalten mit "Potentialdifferenz" bezeichnet. Deutlich ist zu erkennen, dass die Potentialdifferenz über die vier Stunden Messzeit bei den erfindungsgemäßen Proben kaum abfällt. Der kathodische Korrosionsschutz bleibt also auch unter Korrosionsbedingungen lange erhalten.

**Tabelle 1 (Stahlsorten)**

| Stahl | C | Si | Mn | Al | Cr | Nb | Ti | B | P | S | N | Sn | As | Cu | Mo | Ca | Ni |
|---|---|---|---|---|---|---|---|---|---|---|---|---|---|---|---|---|---|
| A | 0,235 | 0,3 | 1,5 | 0,05 | 0,28 | 0,003 | 0,040 | 0,0035 | 0,02 | 0,003 | 0,007 | 0,03 | 0,01 | 0,03 | 0,03 | 0,005 | 0,025 |

Rest Eisen und unvermeidbare Verunreinigungen. Angaben jeweils in Gew.-%,

**Tabelle 2 (Beschichtungsvarianten)**

| Variante | Zusammensetzung Schutzüberzug | | |
|---|---|---|---|
| | Zn | Mn | Sonstige |
| a | 65 | 35 | <1% |
| b | 70 | 30 | <1% |
| c | 75 | 25 | <1% |
| d | 80 | 20 | <1% |
| e | 85 | 15 | <1% |
| f | 90 | 10 | <1% |
| g | 100 | <1% | <1% |

**Tabelle 3 (Herstellungsbedingungen Beschichtung)**

| Versuchsnummer | Stahlsorte | Schichtvariante | Substratdicke [mm] | Substrat-temperatur [°C] | Beschichtungsrate [$\mu$m/s] | Dicke des Schutz-Überzuges [$\mu$m] |
|---|---|---|---|---|---|---|
| 1 | A | a | 1,5 | 500 | 18 | 10 |
| 2 | A | b | 1,5 | 500 | 18 | 10 |
| 3 | A | c | 1,5 | 500 | 18 | 10 |
| 4 | A | d | 1,5 | 500 | 18 | 10 |
| 5 | A | e | 1,5 | 450 | 18 | 10 |
| 6 | A | f | 1,5 | 400 | 18 | 10 |
| 7 | A | 9 | 1,5 | 350 | 18 | 10 |

**Tabelle 4 (Parameter Warmumformung)**

| Warmumformvariante | Mittlere Aufheiz-geschwindigkeit $r_{Ofen}$ [30 - 700 °C] [K/s] | $T_{Ofen}$ [°C] | $t_{Ofen}$ [min.] | Transfer-zeit [s] | Taupunkt Ofen [°C] | $T_{Einlg}$ [°C] | $T_{WZ}$ [°C] | $t_{WZ}$ [s] | Abkühl-geschwindigkeit $r_{WZ}$ [K/s] | $T_{Ziel}$ [°C] |
|---|---|---|---|---|---|---|---|---|---|---|
| I | 8 | 925 | 6 | 8 | -5 | 800 | RT | 15 | 50 | 50 |
| Angaben teilweise gerundet | | | | | | | | | | |

**Tabelle 5 (Blechformteil)**

| Versuch Nr. | Stahl | Beschichtungsvariante | Warmumformvariante | Dicke erste Legierungsschicht [$\mu$m] | Dickenvariation erste Legierungsschicht [%] | Dicke zweite Legierungsschicht [$\mu$m] | Dicke Oxidschicht [$\mu$m] |
|---|---|---|---|---|---|---|---|
| 1 | A | a | I | 11 | 2 | 5 | <1 |
| 2 | A | b | I | 11 | 3 | 4 | <1 |
| 3 | A | c | I | 12 | 2 | 4 | <1 |
| 4 | A | d | I | 12 | 3 | 3 | <1 |
| 5 | A | e | I | 13 | 3 | 2 | <1 |
| 6 | A | f | I | 14 | 2 | 2 | <1 |
| 7 | A | 9 | I | 16 | 1 | 0 | <1 |

**Tabelle 6 (Blechformteil)**

| Versuch Nr. | Stahl | Beschichtungsvariante | Warmumformvariante | Kaltübergangswiderstand [Ω] | Potentialdifferenz Start [V] | Potentialdifferenz 4h [V] | Mittlere Stromdichte [A/m²] | Erfindungsgemäß |
|---|---|---|---|---|---|---|---|---|
| 1 | A | a | — | >0,015 (außerhalb Messbereich) | -0,23 | -0,17 | 0,02 | Nein |
| 2 | A | b | — | >0,015 (außerhalb Messbereich) | -0,46 | -0,42 | 0,20 | Nein |
| 3 | A | c | — | 0,010 | -0,42 | -0,42 | 0,22 | Ja |
| 4 | A | d | — | 0,008 | -0,44 | -0,43 | 0,22 | Ja |
| 5 | A | e | — | 0,006 | -0,45 | -0,43 | 0,22 | Ja |
| 6 | A | f | — | 0,003 | -0,45 | -0,43 | 0,22 | Ja |
| 7 | A | g | — | 0,0003 | -0,47 | -0,44 | 0,23 | Nein |

**Patentansprüche**

1. Stahlflachprodukt zur Herstellung eines Blechformteils durch Warmumformen, aufweisend

   a) ein Stahlsubstrat, das aus einem Stahl, der 0,1 - 3 Gew.-% Mn und optional bis zu 0,01 Gew.-% B aufweist, besteht und
   b) einen auf mindestens einer Seite des Stahlsubstrats angeordneten Schutzüberzug, wobei der Schutzüberzug einen mittleren Gehalt an Zn von 75 - 90 Gew.-% aufweist und im Übrigen aus Mn und unvermeidbaren Verunreinigungen besteht,

   **dadurch gekennzeichnet, dass** ein lokaler Gehalt an Zn um maximal 15 %, insbesondere maximal 10 %, von dem mittleren Gehalt an Zn abweicht.

2. Stahlflachprodukt nach Anspruch 1, **dadurch gekennzeichnet, dass** der mittlere Zn-Gehalt 75 - 85 Gew.-% beträgt.

3. Stahlflachprodukt nach einem der Ansprüche 1 bis 2, **dadurch gekennzeichnet, dass** der Schutzüberzug eine Dicke von 1-20 $\mu$m, bevorzugt 3,0 - 8,0 $\mu$m aufweist.

4. Stahlflachprodukt nach einem der Ansprüche 1 bis 3, **dadurch gekennzeichnet, dass** der Schutzüberzug durch physikalische Gasphasenabscheidung aufgebracht ist.

5. Verfahren zum Herstellen eines Stahlflachprodukts nach einem der Ansprüche 1 bis 4 mit mindestens den folgenden Schritten:

   a) Herstellen oder Bereitstellen eines Stahlsubstrates
   b) Optionales Entölen des Stahlsubstrates
   c) Optionales Dekapieren des Stahlsubstrates
   d) Optionales Erwärmen des Stahlsubstrates
   e) Kontinuierliches Einschleusen des Stahlsubstrates in eine Beschichtungskammer mit einem Unterdruck
   f) Applizieren des Schutzüberzugs mittels physikalischer Gasphasenabscheidung, wobei die Temperatur des Stahlsubstrates beim Applizieren des Schutzüberzuges mindestens 200 °C beträgt
   g) Kontinuierliches Ausschleusen des Stahlsubstrates aus der Beschichtungskammer

6. Verfahren nach Anspruch 5 **dadurch gekennzeichnet, dass** die Beschichtungsrate beim Applizieren des Schutz-überzuges mindestens 0,5 $\mu$m/s beträgt, insbesondere zwischen 0,5 $\mu$m/s und 100 $\mu$m/s, insbesondere zwischen 1 $\mu$m/s und 100 $\mu$m/s, bevorzugt zwischen 2 $\mu$m/s und 20 $\mu$m/s liegt.

7. Verfahren nach einem der Ansprüche 5 bis 6 **dadurch gekennzeichnet, dass** die Temperatur des Stahlsubstrates beim Applizieren des Schutzüberzuges maximal 600 °C beträgt.

8. Verfahren nach einem der Ansprüche 5 bis 7 **dadurch gekennzeichnet, dass** das Applizieren des Schutzüberzuges in einer Schutzgas-Atmosphäre mit einem Druck zwischen 1 mbar und 100 mbar, insbesondere zwischen 10 mbar und 100 mbar stattfindet.

9. Verfahren nach Anspruch 8, **dadurch gekennzeichnet, dass** die Schutzgas-Atmosphäre eine Sauerstoffanteil von weniger als 5 Vol.-% aufweist.

10. Verfahren nach einem der Ansprüche 5 bis 9, **dadurch gekennzeichnet, dass** das Applizieren des Schutzüberzugs mittels physikalischer Gasphasenabscheidung auf das Stahlsubstrat erfolgt, indem das Stahlsubstrat in einer Beschichtungskammer bereitgestellt wird, wobei der Druck in der Beschichtungskammer reguliert wird und wobei eine Legierung mit einem mittleren Gehalt an Zn von 75 - 90 Gew.-% , die im Übrigen aus Mn und unvermeidbaren Verunreinigungen besteht, als Beschichtungsmaterial an einer Einströmstelle in die Beschichtungskammer eingeströmt wird, wobei das Beschichtungsmaterial auf eine Temperatur temperiert wird.

11. Blechformteil, aufweisend

    a) ein Stahlsubstrat, das aus einem Stahl, der 0,1-3 Gew.-% Mn und optional bis zu 0,01 Gew.-% B aufweist, besteht und

b) einen auf mindestens einer Seite des Stahlsubstrats angeordneten Schutzüberzug, wobei der Schutzüberzug umfasst

- eine das Stahlsubstrat kontaktierende erste Legierungsschicht, deren zwei Hauptbestandteile Eisen und Zink sind und
- eine die erste Legierungsschicht kontaktierende zweite Legierungsschicht, deren zwei Hauptbestandteile Mangan und Zink sind

wobei der Schutzüberzug einen mittleren eisenlosen Massenanteil von Zn in Höhe von 75 - 90 Gew.-% aufweist, **dadurch gekennzeichnet, dass** eine Dicke der ersten Legierungsschicht um nicht mehr als 15 % variiert.

12. Blechformteil nach Anspruch 11, wobei die Dicke der ersten Legierungsschicht größer oder gleich der Dicke der zweiten Legierungsschicht ist.

13. Blechformteil nach einem der vorangehenden Ansprüche 11 bis 12, **dadurch gekennzeichnet, dass** der Schutzüberzug eine die zweite Legierungsschicht kontaktierende äußere Schicht mit Manganoxid umfasst, wobei vorzugsweise die Dicke der ersten Legierungsschicht größer oder gleich der Gesamtdicke der zweiten Legierungsschicht und der äußeren Schicht ist.

14. Verfahren zum Herstellen eines Blechformteil, insbesondere nach einem der Ansprüche 11 bis 13, umfassend folgende Arbeitsschritte:

a) Bereitstellen eines Blechzuschnitts aus einem Stahlflachprodukt nach einem der Ansprüche 1 bis 4;
b) Erwärmen des Blechzuschnitts derart, dass zumindest teilweise die AC3-Temperatur des Zuschnitts überschritten ist und die Temperatur TEinlg des Zuschnitts beim Einlegen in ein für ein Warmpressformen vorgesehenes Umformwerkzeug (Arbeitsschritt c)) zumindest teilweise eine Temperatur oberhalb von Ms+100 °C aufweist, wobei Ms die Martensitstarttemperatur bezeichnet;
c) Einlegen des erwärmten Blechzuschnitts in ein Umformwerkzeug, wobei die für das Entnehmen aus der Erwärmungseinrichtung und das Einlegen des Zuschnitts benötigte Transferdauer tTrans höchstens 20 s, bevorzugt höchstens 15 s, beträgt;
d) Warmpressformen des Blechzuschnitts zu dem Blechformteil, wobei der Zuschnitt im Zuge des Warmpressformens über eine Dauer tWZ von mehr als 1 s mit einer zumindest teilweise mehr als 30 K/s betragenden Abkühlgeschwindigkeit rWZ auf die Zieltemperatur TZiel abgekühlt und optional dort gehalten wird;
e) Entnehmen des auf die Zieltemperatur TZiel abgekühlten Blechformteils aus dem Werkzeug.

Europäisches
Patentamt

European
Patent Office

Office européen
des brevets

**EUROPÄISCHER RECHERCHENBERICHT**

Nummer der Anmeldung

**EP 23 19 2887**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2021 107330 A1 (THYSSENKRUPP STEEL EUROPE AG [DE]) 29. September 2022 (2022-09-29) * Zusammenfassung; Ansprüche 1-12 * * Absätze [0011], [0014], [0018], [0023] * ----- | 1-14 | INV. C22C38/02 C22C38/04 C22C38/06 C23C2/06 B32B15/01 C21D1/673 |
| X | JP 2020 158874 A (JFE STEEL CORP) 1. Oktober 2020 (2020-10-01) * Zusammenfassung; Ansprüche 1-4; Tabellen 1-2 * * Absatz [0018] – Absatz [0050] * ----- | 1-14 | C22C18/00 C23C14/16 C22C38/26 C22C38/28 C22C38/32 |
| X | DE 10 2018 128131 A1 (THYSSENKRUPP AG [DE]; THYSSENKRUPP STEEL EUROPE AG [DE]) 14. Mai 2020 (2020-05-14) * Zusammenfassung; Ansprüche 1, 2, 7-15 * ----- | 1-14 | |
| A | WO 2015/090621 A1 (TATA STEEL NEDERLAND TECH BV [NL]) 25. Juni 2015 (2015-06-25) * das ganze Dokument * ----- | 1-14 | **RECHERCHIERTE SACHGEBIETE (IPC)** C22C C23C B32B C21D |

Der vorliegende Recherchenbericht wurde für alle Patentansprüche erstellt

| Recherchenort | Abschlußdatum der Recherche | Prüfer |
|---|---|---|
| Den Haag | 12. Januar 2024 | Mikloweit, Alexander |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
.................................................................................
& : Mitglied der gleichen Patentfamilie, übereinstimmendes
Dokument

EPO FORM 1503 03.82 (P04C03)

**EP 4 512 922 A1**

## ANHANG ZUM EUROPÄISCHEN RECHERCHENBERICHT
## ÜBER DIE EUROPÄISCHE PATENTANMELDUNG NR.

EP 23 19 2887

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-01-2024

| Im Recherchenbericht angeführtes Patentdokument | Datum der Veröffentlichung | Mitglied(er) der Patentfamilie | | Datum der Veröffentlichung |
|---|---|---|---|---|
| DE 102021107330 A1 | 29-09-2022 | CN | 117157429 A | 01-12-2023 |
| | | DE | 102021107330 A1 | 29-09-2022 |
| | | WO | 2022200099 A1 | 29-09-2022 |
| JP 2020158874 A | 01-10-2020 | JP | 7020446 B2 | 16-02-2022 |
| | | JP | 2020158874 A | 01-10-2020 |
| DE 102018128131 A1 | 14-05-2020 | DE | 102018128131 A1 | 14-05-2020 |
| | | EP | 3877564 A1 | 15-09-2021 |
| | | WO | 2020094285 A1 | 14-05-2020 |
| WO 2015090621 A1 | 25-06-2015 | EP | 3084032 A1 | 26-10-2016 |
| | | KR | 20160099588 A | 22-08-2016 |
| | | WO | 2015090621 A1 | 25-06-2015 |

EPO FORM P0461

**IN DER BESCHREIBUNG AUFGEFÜHRTE DOKUMENTE**

**In der Beschreibung aufgeführte Patentdokumente**

- WO 2020094285 A1
- WO 2015090621 A1
- WO 2019122131 A1
- WO 2016042079 A1